# EUROPEAN PATENT APPLICATION

(11) **EP 2 752 892 A1**
(43) Date of publication of application: **09.07.2014**
(21) Application number: 13425138.8
(22) Date of filing: 07.10.2013
(51) Int. Cl.: H01L 31/052

(54) **CONCENTRATION PHOTOVOLTAIC MODULE COMPRISING AT LEAST ONE SUPPORTING ELEMENT FOR OPTICAL RECEIVER - PHOTOVOLTAIC CELL**

(30) Priority: 09.10.2012 IT RM20120477
(71) Applicant: Bartolazzi, Andrea, 00198 Roma (IT)
(72) Inventor: Bartolazzi, Andrea, 00198 Roma (IT)
(74) Representative: Iannone, Carlo Luigi

(57) **Abstract**

The present invention relates to a concentration photovoltaic module (1) comprising:
- at least one photovoltaic cell (4),
- at least one optical receiver (3) for deviating and concentrating sun rays on a respective photovoltaic cell (4), said at least one optical receiver (3) being positioned between the respective photovoltaic cell (4) and the sun,
- at least one supporting element (2) for supporting the respective optical receiver (3) - photovoltaic cell (4) assembly, wherein said supporting element has a longitudinal axis (X),

Said at least one supporting element (2) is normally in a neutral position, substantially parallel to a supporting plane for said concentration photovoltaic module (1), and rotates in both directions with respect to said neutral position about said longitudinal axis (X); said rotation allowing to adjust the azimuth angle of said concentration photovoltaic module (1).

Furthermore, said concentration photovoltaic module comprises moving means (7) for rotating said at least one supporting element (2) with respect to its longitudinal axis (X), so as to allow the positioning in any reachable position.

## Description

The present invention relates to a concentration photovoltaic module comprising at least one supporting element for optical receiver - photovoltaic cell.

More specifically, the invention relates to the structure of a concentration photovoltaic module, which allows each supporting element to rotate about a first axis and/or about a second axis, perpendicular to said first axis.

Currently, there are several known concentration photovoltaic modules.

As it is known, a concentration photovoltaic module includes a photovoltaic cell, e.g. as large as a square having a side of 1 cm, and optical means, generally a Fresnel lens or mirrors, being bigger than such a photovoltaic cell, for deviating and concentrating the sun rays on said photovoltaic cell with the result that said photovoltaic cell is illuminated by a light intensity from 2 to 800 times greater than that of a normal sunny day. This concentration of light is defined as from 2 to 800 suns, which is just to signify the reference to the light intensity of the sun.

In order to increase efficiency, such concentration photovoltaic modules must track the position of the sun in the sky so as to be always aligned to the sun in terms of azimuth angle and elevation angle of the sun, since in the absence of alignment, said optical means would no longer be able to concentrate optimally the sun rays into the focus and the photovoltaic cell, positioned on a plane that is in proximity of the focal plane, would receive a light beam too variable for a correct design. For this purpose, said concentration photovoltaic modules are positioned on a single supporting panel and automatic mechanical devices called trackers are provided for orienting said supporting panel with respect to the sun rays. As a result, all photovoltaic modules mounted on the same supporting panel are oriented with respect to the sun by means of the tracker or trackers provided for said supporting panel.

In particular, in the field of solar concentration a tracker is useful to maintain the focus point, generated by the paraboloid, constant with respect to the photovoltaic cell. The greater is the perpendicular alignment with the sun rays the greater will be the conversion efficiency and the energy produced, where the surface is the same.

A disadvantage of said structure is given by the fact that the supporting elements for the respective lens-photovoltaic cell pairs present in each concentration photovoltaic module are fixed and their orientation follows that of the concentration photovoltaic module, i.e. the orientation of the supporting panel on which the latter is fixed.

A second disadvantage is the need to provide two positioning servo controls, respectively one for the azimuth and a second for the elevation, having a complex structure, and being expensive.

Another disadvantage is given by the difficulty of integrating a concentration photovoltaic module in a fixed structure, such as the roof of a building or of a greenhouse.

Again a disadvantage is the fact that the concentration photovoltaic module generates a shadow in the environment below, making it difficult operations which may be performed in said environment, such as the cultivation or any activity which might be carried out in an illuminated environment.

Object of the present invention is to overcome said disadvantages by providing a concentration photovoltaic module comprising at least one supporting element for the production of a greater amount of electrical energy, having a simplified structure and a low cost.

A further object of the invention is to provide a concentration photovoltaic module that allows the passage and adjustment of the amount of sun rays within an environment in such a way that said environment can be directly illuminated by the sun rays.

This has been obtained by a concentration photovolatic module comprising:
- at least one photovoltaic cell,
- at least one optical receiver for deviating and concentrating sun rays on a respective photovoltaic cell, said at least one optical receiver being positioned between the respective photovoltaic cell and the sun,
- at least one supporting element for supporting the respective optical receiver - photovoltaic cell assembly, said supporting element having a longitudinal axis,

In particular, said at least one supporting element is normally in a neutral position, substantially parallel to a supporting plane for said concentration photovoltaic module, and rotates in both directions with respect to said neutral position about said longitudinal axis. Said rotation allows to adjust the azimuth angle of said concentration photovoltaic module.

The concentration photovoltaic module further comprises moving means for rotating said at least one supporting element with respect to its longitudinal axis, so as to allow the positioning in any reachable position.

According to the invention, the concentration photovoltaic module can comprise a plurality of supporting elements, each of which can support a respective optical receiver - photovoltaic cell assembly.

Advantageously, when the concentration photovoltaic module comprises a plurality of supporting elements, said concentration photovoltaic module can comprise coupling means for coupling said plurality of supporting elements so that said plurality of supporting elements is integrally movable with respect to said longitudinal axis.

According to the invention, each supporting element can comprise coupling means for coupling said optical receiver with said photovoltaic cell so as to allow the respective tilting movement of each supporting element with respect to said longitudinal axis.

In particular, said coupling means can comprise two connecting elements, substantially vertical, which are tilting with respect to said longitudinal axis, so that each supporting element translates from an initial position, in which said connecting elements are orthogonal to the plane on which said optical receiver is arranged, to a final position, where said connecting elements are inclined wich respect to the plane on which said optical receiver is arranged. The passage from said initial position to said final position of said supporting elements allows to adjust the angle of elevation of said concentration photovoltaic module.

Again according to the invention, said concentration photovotlaic module can comprise at least one guide, associated with a sun path, and an arm, sliding in said at least one guide, and movable inside the same, as a result of the movement of said at least one supporting element with respect to said longitudinal axis.

It is preferable that said concentration photovoltaic module comprises a plurality of guides as well as moving means for moving said arm from one guide to another, depending on the sun path appropriate to the latitude and to season of the year.

Said moving means can comprise a connecting element for connecting said guides so that said arm enters and exits from each of said guides, wherein in the translational motion of each supporting element from said initial position to said final position, said arm is slidably pivoted on one of said guides and/or of said connecting element. Furthermore, said concentration photovoltaic module can further comprises a pushing element for pushing said arm in one of said guides; the selection of one of said guides being a function of the height of the sun above the horizon during the year.

It is preferable that said guides are curved, and arranged in succession in such a way that their amplitude is increasing, wherein each of said guides has a first end and a second end, and that said connecting element connects said first ends and said second ends of said guides. Said connecting element has a first end and a second end, wherein at least one end of said connecting element being external with respect to one end of the guide with the greatest amplitude. Said connecting element being also a guide element for guiding said arm from a first position, corresponding to a first point substantially at the center of said connecting element, to a second position, corresponding to a second point of said connecting element which is either between two ends of two successive guides or between one end of the guide with the greatest amplitude and one of the ends of said connecting element. Said pushing element can be positioned in proximity to said first ends or said second ends, and can be configured to block said arm in said second point of said connecting element, when each supporting element is rotated by a given angle in a first direction, and to push said arm in one of said guides, when said moving means rotate each supporting element in a second direction, opposite to said first direction.

It is preferable that said moving means comprise detection means for detecting the position of said moving means.

According to the invention, the optical receiver of at least one supporting element can comprise three portions, a central portion, a first end portion, and a second end portion, each of which has a respective focus, where the focuses of the end portions are positioned on a portion of a plane opposite to that containing the respective end portion with respect to an axis passing through a photovoltaic cell of a supporting element and the focus of the central portion.

In a first configuration of said optical receiver, the focus of said central portion can lie on a first plane, said first plane being at a first distance from the photovoltaic cell, and the focuses of said end portions can lie on a second plane, said second plane being at a second distance from said photovoltaic cell, wherein said second distance can be greater or less than said first distance.

In a second configuration of said optical receiver, the focus of said central portion and the focuses of said end portions can lie on the same plane.

The present invention will be now described, for illustrative, but not limitative purposes, according to an embodiment, making particular reference to the enclosed drawings, wherein:
Figure 1 shows a first embodiment of the concentration photovoltaic module, object of the invention, comprising a plurality of supporting elements for a respective optical receiver - photovoltaic cell assembly, wherein the receiver optical has been removed from one of said support elements;
Figure 2 shows the concentration photovoltaic module of Fig. 1, once each supporting element for the optical receiver - photovoltaic cell assembly has done a rotation;
Figure 3 is a side view of the supporting elements for the optical receiver - photovoltaic cell assembly of Fig. 2;
Figure 4 shows an application of the concentration photovoltaic module according to the invention as a cover of a greenhouse;
Figure 5 shows schematically a second embodiment of the concentration photovoltaic module, according to the invention, comprising an arm and a plurality of guides for said arm, wherein a respective sun path is associated to each of them;
Figure 6 shows a detail of the concentration photovoltaic module of Fig. 5, referred to the guides of said arm;
Figure 7 shows the concentration photovoltaic module of Fig. 5 when the supporting elements for the optical receiver - photovoltaic cell assembly have been rotated by a given angle in the same direction;
Figure 8 shows the arm when it slides over a first guide;
Figure 9 shows schematically a third embodiment of a concentration photovoltaic module, according to the invention, wherein each optical receiver comprises three portions;
Figure 10 shows a detail of the concentration photovoltaic module of Fig. 9, referred to an optical receiver.

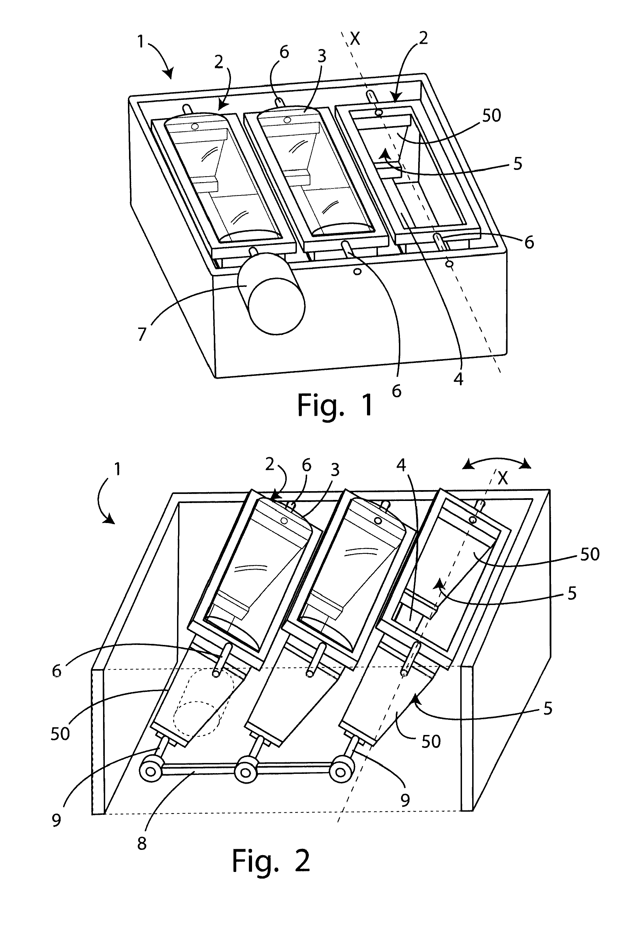

With reference to Figures 1-3, in the first embodiment that is described, a concentration photovoltaic module 1 is provided, wherein said concentration photovoltaic module comprises a plurality of photovoltaic cells 4, a plurality of optical receivers 3 for deviating sun rays on a respective photovoltaic cell 4, and a plurality of supporting elements 2 for supporting a respective optical receiver 3 and a photovoltaic cell 4 assembly, each of said supporting element having a longitudinal axis X.

In particular, each optical receiver 3 is positioned between a respective photovoltaic cell 4 and the sun, at a predetermined distance from said photovoltaic cell 4, and each photovoltaic cell 4 is positioned between the respective optical receiver 3 and the focal plane of the same.

According to the invention, each supporting element 2 comprises coupling means 5 for coupling said optical receiver 3 with said photovoltaic cell 4, and each supporting element 2 is rotatably coupled to the internal structure of the concentration photovoltaic module 1, by means of two pins 6, so as to rotate in a bidirectional manner around said longitudinal axis X.

In the embodiment being described, the supporting elements 2 pass from a first position, wherein each optical receiver 3 is arranged on a first plane or reference plane (fig. 1), and a second position, wherein each receiver optical 3 is arranged on a respective second plane, inclined with respect to said reference plane, forming with it an angle (fig. 2).

According to the invention, the concentration photovoltaic module 1 comprises moving means 7 for moving each supporting element 2 between said first position and said second position, and vice versa. Such moving means 7 allow to adjust the concentration photovoltaic module 1 in terms of azimuth angle.

More generally, without departing from the scope of the invention, the supporting elements 2 are normally in a neutral position, substantially parallel to a supporting plane for said concentration photovoltaic module 1, and are capable of rotating in both directions with respect to said neutral position around said longitudinal axis X, entraining in rotation with them the optical receiver 3 - photovoltaic cell 4 assembly, associated with them. The moving means 7 rotate said supporting elements 2 with respect to their longitudinal axes, so as to allow the positioning of each supporting element 2 in any reachable position.

In order for all the supporting elements 2 of the concentration photovoltaic module 1 to rotate by a given angle in the same direction, said supporting elements 2 are connected each other through coupling means 8 coupled to each of said supporting elements 2 by means of a respective pin 9 (Figs. 2-3). In the example that is described, said coupling means 8 comprise a rod.

In the example that is described, said moving means 7 comprise detection means for detecting the position of the moving means themself, such as in case of a step by stepr motor. Furthermore, each photovoltaic cell 4 is connected to an inverter (not shown) through electric current conducting means (not shown), and each optical receiver 3 comprises a lens. Said lens can be a Fresnel lens.

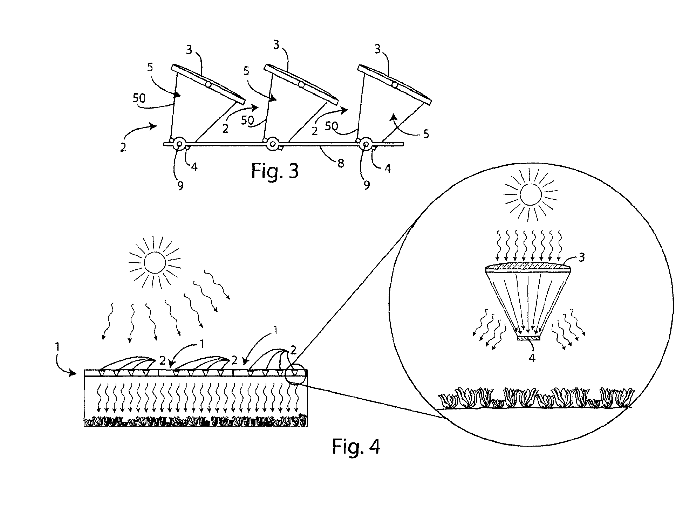

In Figure 4 an application of a plurality of said concentration photovoltaic modules 1 is shown, wherein said plurality of said concentration photovoltaic modules is used as a covering element or roof for a greenhouse, inside of which plants are present.

As visible in Figure 4, on the one hand a first amount of sun rays, having a direction so to directly hit the respective photovoltaic cell and/or deviated by the optical receiver 3 on the respective photovoltaic cell 4, hits said photovoltaic cell 4 so that said first amount can be transformed into electricity current. On the other hand, a second amount of sun rays, having a direction so that they do not directly hit the respective photovoltaic cell 4 and/or deviated by the optical receiver 3 so that thay do not hit the respective photovoltaic cell 4, penetrates inside the greenhouse so as to illuminate and heat the interior space of the greenhouse itself.

The detail shown in the circle of Figure 4 shows how a part of the light radiation is concentrated on the photovoltaic cell 4 and another part of the light radiation penetrates the greenhouse. The passage of sun rays inside the greenhouse promotes the heating of the greenhouse and the growth of plants. Furthermore, in the case of reflected and/or scattered light, the light radiation penetrating inside the greenhouse is greater than the direct light radiation as it is not picked up by the optical receiver 3.

In order to allow the sun rays to penetrate inside the greenhouse, the concentration photovoltaic module 1 has a wall having at least a portion of transparent material to allow the sun rays that do not hit a photovoltaic cell 4 and/or that are not deviated on said photovoltaic cell to pass from outside to inside of the greenhouse. In alternative to the transparent portion, the concentration photovoltaic module can be provided with an opening or a hole.

In the application that is described, the concentration photovoltaic modules 1 can be coupled to each other in such a way that they are disposed side by side and it is provided that only one of said concentration photovoltaic modules is provided with moving means 7.

However, although in Figure 4 the concentration photovoltaic modules 1 are used to form the roof of a greenhouse, said concentration photovoltaic modules 1 can be applied on any structure fixed to illuminate and/or heat the indoor environment of said greenhouse.

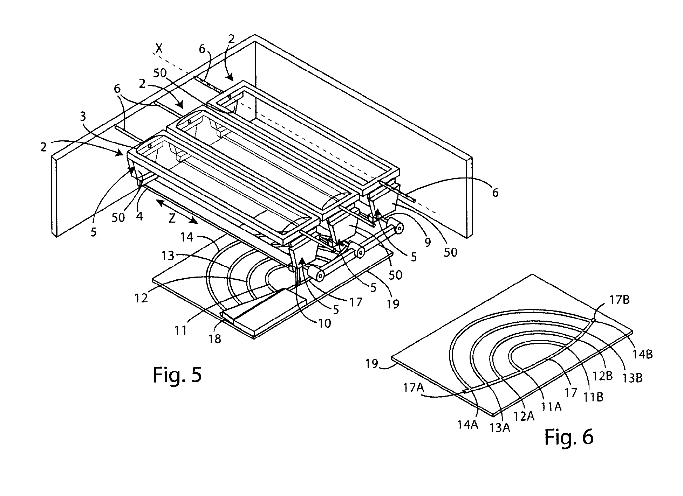

In Figure 5 a second embodiment of the concentration photovoltaic module 1 is shown, wherein said concentration photovoltaic module comprises an arm 10, a plurality of guides 11, 12, 13, 14 for said arm disposed in succession, curved and substantially concentric, wherein a respective sun path is associated with each of them, as well as a pushing element 18, coupled to the internal structure of said concentration photovoltaic module, for pushing said arm 10 in one of said guides. Said pushing element 18 can be an elastic element or a magnet. In the latter case , it is provided that the arm 10 has at least a portion comprising a magnetic material.

In particular, the coupling means 5 for coupling said optical receiver with said photovoltaic cell are configured for coupling said optical receiver 3 with said photovoltaic cell 4 so as to allow the respective tilting movement of each supporting element 2 with respect to its longitudinal axis X, as indicated by the double arrow Z. More particularly, said coupling means 5 comprise two connecting elements 50, substantially vertical, which are tilting with respect to the longitudinal axis X.

In the embodiment being described, four guides, substantially concentric, are provided, a first guide 11, a second guide 12, a third guide 13, a fourth guide 14. However, although not shown in the figures, it is possible to provide any number of guides as well as it is possible to provide guides disposed succession, with an amplitude increasing in the direction that goes from one wall of the concentration photovoltaic module towards its interior, which are not intersect each other, and which are not necessarily substantially concentric or circular.

Each of said guides 11, 12, 13, 14 has a first end 11 A, 12A, 13A, 14A and a second end 11B, 12B, 13B, 14B, and it is provided a connetting element 17 which connects the ends of said guides in such a way that said arm 10 can enter and exit a respective guide means of said first end and said second end. Also said connetting element 17 has a first end 17A and a second end 17B and has a length dimensioned so that said first ends and said second ends of said guide are inside of its ends 17A, 17B (Fig. 6). However, it is sufficient that said connecting element 17 has a length that exceeds one of the ends of the guide with the greatest amplitude, i.e. the fourth guide 14.

According to the invention, the concentration photovoltaic module 1 comprises a supporting element 19 coupled to the internal structure of the concentration photovoltaic module 1 itself for supporting said guides 11, 12, 13, 14, said connecting element 17 and said pushing element 18.

In the embodiment that is described, said guides 11, 12, 13, 14, and said connecting element 17 respectively comprise a groove provided on said supporting element 19.

Simultaneously with the passage from the first position to the second position of said supporting elements 2 for adjusting the azimuth angle of the concentration photovoltaic module 1, the sliding of said arm 10 on one of said guides allows each supporting element 2 to translate from an initial position, wherein said connecting elements 50 are orthogonal to the plane on which said optical receiver 3 is disposed, to a final position, wherein said connecting elements 50 are inclined with respect to the plane on which said optical receiver 3 is disposed. The angle of elevation of the concentration photovoltaic module 1 is adjusted by the translation of each supporting element 2. The selection of the guide inside which said arm 10 slides is in function of the height of the sun on the horizon during the year. Hence, a guide is selected depending on the solar path appropriate to the latitude and season of the year.

In particular, the arm 10 has a first end coupled to a movable supporting element 2 and a second end which is slidably pivoted on said connecting element 17 and on said guides 11, 12, 13, 14.

As shown in Figure 5, when movable supporting element 2 is in the first position, i.e. in the position wherein each optical receiver 3 is disposed on a reference plane, the arm 10 is slidably pivoted on said connecting element 17 in a first position, corresponding to a first point, substantially at the center of said connecting element 17.

During the passage from the first position to the second position of the movable supporting elements 2 for adjusting the angle of elevation of the concentration photovoltaic module 1, said movable supporting elements 2 are rotated by a given angle in a first direction, and the arm 10 slides along said connecting element 17 in a second direction, opposite to said first direction, moving from said first position to a second position, corresponding to a second point of said connecting element 17, which is either between two first ends of two successive guides or between the first end of the guide with the greatest amplitude (fourth guide 14) and the first end 17A of said connecting element 17.

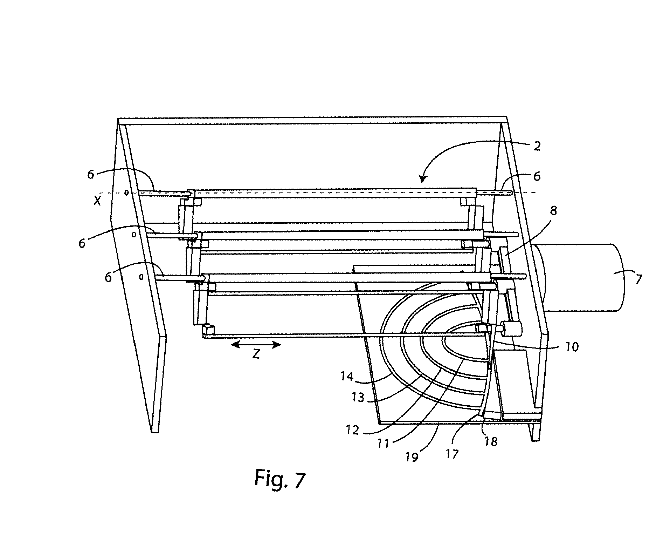

Figure 7 shows the movable supporting elements 2 rotated by an azimuth angle of 25 ° in a first direction.

As it is possible to see from Figure 7, the arm 10 has slided on said connecting element 17 from the center to a point of said connecting element 17 which is between said first guide 11 and said second guide 12, overcoming the resistance of said element thrust 18.

In other words, the arm 10 remains slidably pivoted on said connecting element 17 during the passage from its first position to its second position.

When said arm 10 is pivoted on said connecting element 17 at a point between the first end 11 A of said first guide 11 and the first end 12A of said second guide 12, said pushing element 18 insists on an end portion of said arm 10 so that said arm is blocked between the pushing element 18 and an edge of said connecting element 17.

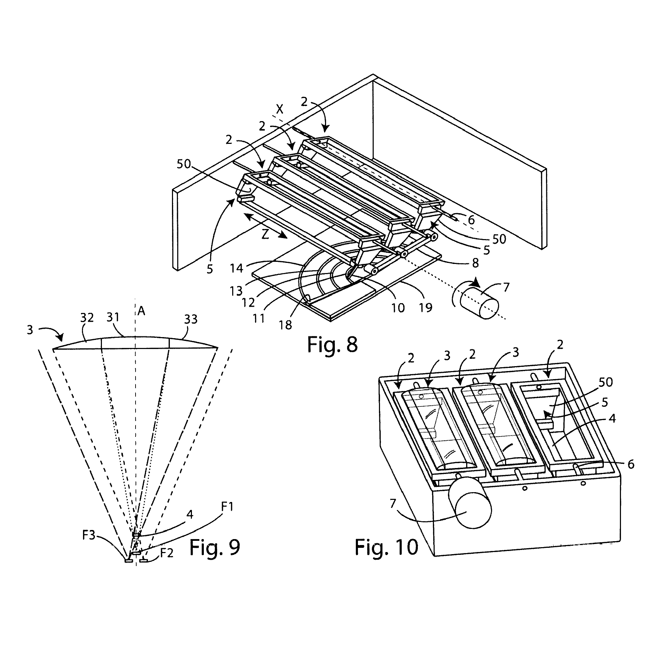

When the movable supporting elements 2 are rotated by said moving means 7 in a second direction, opposite to said first direction, the arm 10 slides in the direction opposite to said second direction and is pushed by the pushing element 18 in the first guide 11 (fig. 8)

When the arm 10 slides in the first guide 11, each movable supporting element 2 translates from an initial position, wherein said connecting elements 50 are orthogonal to the plane on which said optical receiver 3 is disposed, to a final position, wherein said connecting elements 50 are inclined with respect the plane on which said optical receiver 3 is disposed. As already said, the translation of each movable supporting element 2 allows to adjust the concentration photovoltaic module in terms of angle of elevation.

The guides 11, 12, 13, 14 corresponding to respective sun paths are configured in such a way that during the translation of each supporting element 2 the sun rays incident on the photovoltaic cell 4 are parallel to the connecting elements 50, so as to reduce the formation of shadow zones at the ends of the photovoltaic cells.

Once the arm 10 has finished its run on any point of said first guide, said arm 11 is first brought towards the second end 11 B of the first guide 11, i.e. the end of the first guide 11 opposite to that which has allowed the same arm to enter the first guide itself, and then brought back by the moving means 7 in its initial position, at the center of the connecting element 17, before another sun path is selected, i.e. before the arm 10 slides on another guide.

Furthermore, although not shown in the figures, it is possible to provide that each second end 11 B, 12B, 13B, 14B of the guides 11, 12, 13, 14 is provided with a flap to allow the arm 10 to exit by a respective guide and avoid that said arm accidentally enters the same guide, from where it originally came out.

In figure 9 a third embodiment of a concentration photovoltaic module 1 is shown, wherein the optical receiver 3 of each movable supporting element 2 comprises three portions, of which a central portion 31, a first end portion 32, and a second end portion 33, each of which has a respective focus F1, F2, F3.

In particular, the focuses F2 and F3 are positioned on a portion of the plane opposite to that containing the respective end portion 32, 33 with respect to an axis A passing through the photovoltaic cell 4 of the supporting element 2 and the focus F1 of the central portion 31.

Moreover, the focus F1 of said central portion 31 lies on a first plane which is at a first distance from the photovoltaic cell 4, whilst the respective focuses F2, F3 of said end portions 32, 33 lie on a second plane which is at a second distance from said photovoltaic cell 4, wherein said second distance is greater than said first distance (fig. 10).

Said focuses F1, F2, F3 are arranged in such a way as to form an isosceles triangle, wherein the first and the second vertex of the base are constituted by the two focuses F2, F3 of the end portions 32,33, and the third vertex is constituted by the focus F1 of the central portion 31.

Although in the third embodiment the second plane, on which the focuses F2, F3 of the end portions 32, 33 lie, is at a second distance from the photovoltaic cell 4 which is greater than the first distance between the photovoltaic cell 4 and the first plane on which the focus F1 of the central portion 31 lies, said focuses F2, F3 can lie on a plane at a distance from the photovoltaic cell 4 less than that between the photovoltaic cell 4 and the plane on which the focus F1 of the central portion 31, or said focuses F2, F3 of the end portions 32, 33 and said focus F1 of the central portion 31 can lie on the same plane, without departing from the scope of the invention. In the latter case, the focuses are arranged on the same plane so as to be aligned and equidistant each other.

Each end portion 32, 33 is arranged laterally to said central portion 31 in such a way that the greatest amount of sun rays incident on said end portions 32, 33 is deviated on the photovoltaic cell 4, on which also sun rays incident on said central portion 31 are deviated. Advantageously, by means of an optical receiver 3 so configured, it is possible to reduce the formation of shadow zones generated at one end of the photovoltaic cell 4 of a movable supporting element 2 due to an adjacent supporting element. In fact, when said movable supporting elements 2 are rotated by a given angle, an end portion of an optical receiver 3 of a supporting element 2 is darkened by the adjacent supporting element. The reduction of shadow zones implies a better photovoltaic sealing of the photovoltaic cell.

For each of the embodiments described above, it is preferable to provide respective cooling means (not shown) for each photovoltaic cell 4 of each supporting element 2, disposed in contact with said photovoltaic cell 4, as the sun rays which directly hit the photovoltaic cell 4 and/or which are deviated by the optical receiver 3 on said photovoltaic cell 4 heat the photovoltaic cell itself, excessively from time to time. Said cooling means may allow the passage of a fluid inside them, such as air or liquid.

Advantageously, it is possible to track the sun through the concentration photovoltaic module object of the invention, adjusting the azimuth angle and preferable the elevation angle, so that a greater amount of the sun rays are deviated on the photovoltaic cell of each movable supporting element to be transformed in electrical current.

The present invention has been described for illustrative, but not limitative purposes with reference to a preferred embodiment, but it well evident that one skilled in the art can introduce modifications to the same without departing from the relevant scope, as defined in the enclosed claims.

## Claims

1. Concentration photovoltaic module (1) comprising:
- at least one photovoltaic cell (4),
- at least one optical receiver (3) for deviating and concentrating sun rays on a respective photovoltaic cell (4), said at least one optical receiver (3) being positioned between the respective photovoltaic cell (4) and the sun,
- at least one supporting element (2) for supporting the respective optical receiver (3) - photovoltaic cell (4) assembly, said supporting element having a longitudinal axis (X),
said concentration photovoltaic module being **characterized in that**
said at least one supporting element (2) is normally in a neutral position, substantially parallel to a supporting plane for said concentration photovoltaic module (1), and rotates in both directions with respect to said neutral position about said longitudinal axis (X); said rotation allowing to adjust the azimuth angle of said concentration photovoltaic module (1);
and **in that** the concentration photovoltaic module comprises moving means (7) for rotating said at least one supporting element (2) with respect to its longitudinal axis (X), so as to allow the positioning in any reachable position.

2. Concentration photovoltaic module (1) according to claim 1, **characterized in that** it comprises a plurality of supporting elements (2), each of which supports a respective optical receiver (3) - photovoltaic cell (4) assembly.

3. Concentration photovoltaic module (1) according to claim 2, **characterized in that** it comprises coupling means (8) for coupling said plurality of supporting elements (2) so that said plurality of supporting elements (2) is integrally movable with respect to said longitudinal axis (X).

4. Concentration photovotlaic module (1) according to any one of the preceding claims, **characterized in that** each supporting element (2) comprises coupling means (5) for coupling said optical receiver (3) with said photovoltaic cell (4) so as to allow the respective tilting movement of each supporting element (2) with respect to said longitudinal axis (X).

5. Concentration photovotlaic module (1) according to claim 4, **characterized in that** said coupling means (5) comprise two connecting elements (50), substantially vertical, which are tilting with respect to said longitudinal axis (X), so that each supporting element (2) translates from an initial position, in which said connecting elements (50) are orthogonal to the plane on which said optical receiver (3) is arranged, to a final position, where said connecting elements (50) are inclined wich respect to the plane on which said optical receiver (3) is arranged; the passage from said initial position to said final position of said supporting elements (2) allowing to adjust the angle of elevation of said concentration photovoltaic module (1).

6. Concentration photovotlaic module (1) according to any one of the preceding claims, **characterized in that** it comprises:
at least one guide (11,12,13,14), associated with a sun path, and
an arm (10), sliding in said at least one guide, and movable inside the same, as a result of the movement of said at least one supporting element (2) with respect to said longitudinal axis (X).

7. Concentration photovotlaic module (1) according to claim 6, **characterized in that** it comprises a plurality of guides (11,12,13,14); said concentration photovoltaic module further comprising moving means for moving said arm (10) from one guide to another, depending on the sun path appropriate to the latitude and to season of the year.

8. Concentration photovoltaic module (1) according to claim 7, **characterized in that** said moving means comprise a connecting element (17) for connecting said guides (11,12,13,14) so that said arm (10) enters and exits from each of said guides; in the translational motion of each supporting element (2) from said initial position to said final position, said arm being slidably pivoted on one of said guides (11,12,13,14) and/or of said connecting element (17),
and **in that** the concentration photovoltaic module further comprises a pushing element (18) for pushing said arm (10) in one of said guides (11,12,13,14), the selection of one of said guides (11,12,13,14) being a function of the height of the sun above the horizon during the year.

9. Concentration photovoltaic module (1) according to claim 8, **characterized in that** said guides (11,12,13,14) are curved, and arranged in succession in such a way that their amplitude is increasing, each of said guides having a first end (11 A, 12A, 13A, 14A) and a second end (11B, 12B, 13B, 14B),
**in that** said connecting element (17) connects said first ends (11A, 12A, 13A, 14A) and said second ends (11B, 12B, 13B, 14B) of said guides (11,12,13,14), said connecting element having a first end (17A) and a second end (17B), at least one end (17A, 17B) of said connecting element being external with respect to one end of the guide with the greatest amplitude; said connecting element being also a guide element for guiding said arm (10) from a first position, corresponding to a first point substantially at the center of said connecting element (17), to a second position, corresponding to a second point of said connecting element (17) which is either between two ends (11A, 12A, 13A, 14A; 11 B, 12B, 13B, 14B) of two successive guide or between one end (14A; 14B) of the guide with the greatest amplitude and one of the ends (17A, 17B) of said connecting element (17), and
**in that** said pushing element (18) is positioned in proximity to said first ends (11A, 12A, 13A, 14A) or said second ends (11B, 12B, 13B, 14B), and is configured to block said arm (10) in said second point of said connecting element (17), when each supporting element (2) is rotated by a given angle in a first direction, and to push said arm (10) in one of said guides (11, 12,13,14), when said moving means (7) rotate each supporting element (2) in a second direction, opposite to said first direction.

10. Concentration photovoltaic module (1) according to any one of the preceding claims, **characterized in that** said moving means (7) comprise detection means for detecting the position of said moving means.

11. Concentration photovoltaic module (1) according to any one of claim 1-10, **characterized in that** said optical receiver comprises three portions, a central portion (31), a first end portion (32), and a second end portion (33), each of which has a respective focus (F1, F2, F3), where the focuses (F2, F3) of the end portions (32, 33) are positioned on a portion of a plane opposite to that containing the respective end portion (32, 33) with respect to an axis (A) passing through a photovoltaic cell (4) of a supporting element (2) and the focus (F1) of the central portion (31).

12. Concentration photovoltaic module (1) according to claim 11, **characterized in that** the focus (F1) of said central portion (31) lies on a first plane, said first plane being at a first distance from the photovoltaic cell (4), and the focuses (F2, F3) of said end portions (32, 33) lie on a second plane, said second plane being at a second distance from said photovoltaic cell (4), wherein said second distance is greater or less than said first distance.

13. Concentration photovoltaic module (1) according to claim 11, **characterized in that** said focus (F1) of said central portion (31) and said focuses (F1, F2, F3) of said end portions (32,33) lie on the same plane.
